Europäisches Patentamt

European Patent Office

Office européen des brevets

(19)

(11) Numéro de publication: **0 169 594**
**B1**

(12) **FASCICULE DE BREVET EUROPEEN**

(45) Date de publication du fascicule du brevet:
29.11.89

(21) Numéro de dépôt: 85200983.6

(22) Date de dépôt: 20.06.85

(51) Int. Cl.⁴: **G 05 F 3/24,** H 01 P 1/20,
H 03 H 11/48

(54) Circuit de polarisation reglable et de liaison hyperfrequence.

(30) Priorité: 29.06.84 FR 8410368

(43) Date de publication de la demande:
29.01.86 Bulletin 86/5

(45) Mention de la délivrance du brevet:
29.11.89 Bulletin 89/48

(84) Etats contractants désignés:
DE FR GB IT SE

(56) Documents cités:
GB-A- 1 109 891
US-A- 4 023 125
US-A- 4 078 217
US-A- 4 401 952

SOLID STATE ELECTRONICS, vol. 8, 1965, pages
775-788, Pergamon Press, Oxford, GB; H.C. JOSEPHS et
al.: "Solid state inductors"
ELECTRONICS AND COMMUNICATIONS IN JAPAN, vol.
56-C, no. 8, 1973, pages 85-93, Washington, US; S.
NOGUCHI et al.: "Characteristics of inductive
reactance using multistage RC phase-shift network and
its application"

(73) Titulaire: R.T.C. COMPELEC, Société Anonyme,
130 Avenue Ledru Rollin, F-75011 Paris (FR)
(84) Etats contractants désignés: FR

(73) Titulaire: N.V. Philips' Gloeilampenfabrieken,
Groenewoudseweg 1, NL-5621 BA Eindhoven (NL)
(84) Etats contractants désignés: DE GB IT SE

(72) Inventeur: Giakoumis, Alex, Société Civile
S.P.I.D. 209, rue de l'Université, F-75007 Paris (FR)

(74) Mandataire: Pinchon, Pierre et al, Société Civile
S.P.I.D. 209 rue de l'Université, F-75007 Paris (FR)

(56) Documents cités: (suite)
THE ELECTRONIC ENGINEER, septembre 1969, pages
64-71, Radnor, GB; B. BOTOS: "Get regulated current
with FETs"
IBM TECHNICAL DISCLOSURE BULLETIN, vol. 13, no. 9,
février 171, page 2659, New York, US; J.C. HSIEH et al.:
"MOSFET storage chip bit line bias generator"

ACTORUM AG

### Description

La présente invention concerne un circuit de polarisation réglable et de liaison hyperfréquence, fournissant sur une borne de sortie une tension de polarisation ajustable, en réponse aux variations d'une tension continue de commande appliquée à une borne de commande, et transmettant avec une faible atténuation un signal hyperfréquence entre une borne d'entrée et la borne de sortie, lesdites bornes d'entrée et de sortie étant connectées entre elles par un condensateur de découplage.

Un circuit de polarisation réglable et de liaison hyperfréquence du type de celui décrit dans le préambule est connu du livre intitulé «Radio and Television Engineers' Reference Book» pages I–48 and I–63. Ce circuit est constitué, en plus du condensateur de découplage, par une inductance élevée reliant la borne de commande à la borne de sortie. Dans ce circuit classique, la tension continue de commande est directement appliquée à la borne de sortie, l'inductance présentant une impédance négligeable. Par contre, en hyperfréquence, le condensateur et l'inductance ont une impédance respectivement très faible et très élevée, de sorte que le signal hyperfréquence est transmis sans atténuation de la borne d'entrée à la borne de sortie. Ce type de circuit connu présente cependant l'inconvénient de ne pas être facilement intégrable car, étant constitué d'un condensateur et d'une inductance, il occupe une surface très importante, ce qui en augmente considérablement le coût.

Le brevet GB-A 1 109 891 divulgue, par exemple à la fig. 1, un circuit qui est, effectivement, sensé jouer le rôle d'une inductance tout en étant d'intégration plus aisée.

Le but de la présente invention est de remédier à cet inconvénient en proposant un circuit de polarisation réglable et de liaison hyperfréquence facilement intégrable sur une faible surface.

En effet, selon la présente invention, un circuit de polarisation réglable et de liaison hyperfréquence, fournissant sur une borne de sortie une tension de polarisation ajustable, en réponse aux variations d'une tension continue de commande appliquée à une borne de commande, et transmettant avec une très faible atténuation un signal hyperfréquence entre une borne d'entrée et la borne de sortie, lesdites bornes d'entrée et de sortie étant connectées entre elles par un condensateur de découplage, est notamment remarquable en ce qu'il comporte un premier transistor à effet de champ dont la source est alimentée par un générateur de courant constant et est reliée à la borne de sortie, tandis que la grille du transistor est reliée, d'une part, à la borne de commande par une résistance, et, d'autre part, à la source du transistor par un élément capacitif.

Ainsi, comme on le verra en détail plus loin, le transistor à effet de champ fonctionne à courant drain-source constant, ce qui, pour des valeurs suffisamment élevées de la tension drain-source, typiquement supérieures à 1 volt, correspond à un fonctionnement à tension grille-source constante. La tension appliquée à la grille étant sensiblement égale à la tension continue de commande, la tension de polarisation de sortie est reliée linéairement à la tension de commande. Par ailleurs, en hyperfréquence, l'élément capacitif constitue un court-circuit entre la grille et la source du transistor à effet de champ qui fonctionne alors à tension alternative grille-source nulle avec pour conséquence que le transistor présente une impédance de sortie élevée. La résistance ayant elle-même une valeur élevée, la transmission du signal hyperfréquence par le circuit selon l'invention se fait sans ou avec une très faible atténuation.

Dans un mode de réalisation avantageux de l'invention, le générateur de courant constant est constitué par un deuxième transistor à effet de champ dont le courant entre le drain et la source reste sensiblement constant lors des variations de la tension continue de commande.

Comportant essentiellement deux transistors à effet de champ, le circuit selon l'invention peut être réalisé sous forme intégrée sur une petite surface et ce d'autant plus qu'il est prévu que l'élément capacitif est constitué par une diode polarisée en inverse.

La description qui va suivre en regard des dessins annexés, donnés à titre d'exemples non limitatifs, fera bien comprendre en quoi consiste l'invention et comment elle peut être réalisée.

La figure 1 est un schéma d'un circuit de polarisation réglable et de liaison hyperfréquence selon l'invention.

La figure 2 est un diagramme de fonctionnement du circuit de la figure 1.

La figure 3 est un schéma d'un mode de réalisation du circuit de la figure 1.

La figure 4 est un graphique donnant les variations de la tension ajustable en fonction de la tension de commande.

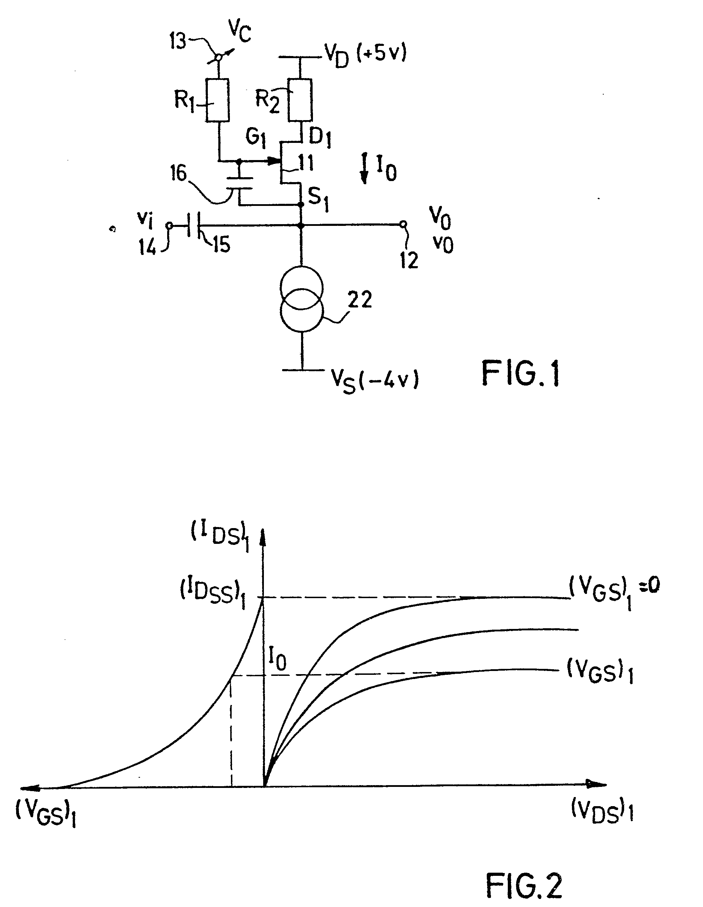

La figure 1 montre un circuit de polarisation réglable et de liaison hyperfréquence, fournissant sur une borne 12 de sortie une tension Vo de polarisation ajustable, en réponse aux variations d'une tension Vc continue de commande appliquée à une borne 13 de commande. Ce circuit transmet avec une faible atténuation un signal hyperfréquence entre une borne 14 d'entrée et la borne 12 de sortie, lesdites bornes d'entrée et de sortie étant connectées entre elles par un condensateur 15 de découplage. Comme on peut le voir à la figure 1, le circuit selon l'invention comporte un premier transistor 11 à effet de champ dont la source S1 est alimentée par un générateur 22 de courant constant et est reliée à la borne 12 de sortie. Par ailleurs, la grille G1 du transistor 11 est reliée, d'une part, à la borne 13 de commande par une résistance R1 et, d'autre part, à la source S1 du transistor 11 par un élément capacitif 16.

Le courant de grille du transistor 11 étant de l'ordre de quelques nanoampères, la chute ohmique introduite par la résistance R1 (de l'ordre de quelques dizaines de kiloohms) est négligeable, de sorte que l'on peut écrire

$$VG1 = Vc$$

La tension Vo de polarisation à la borne 12 de sortie vaut donc

$$Vo = Vc - (V_{GS})_1 \quad (1)$$

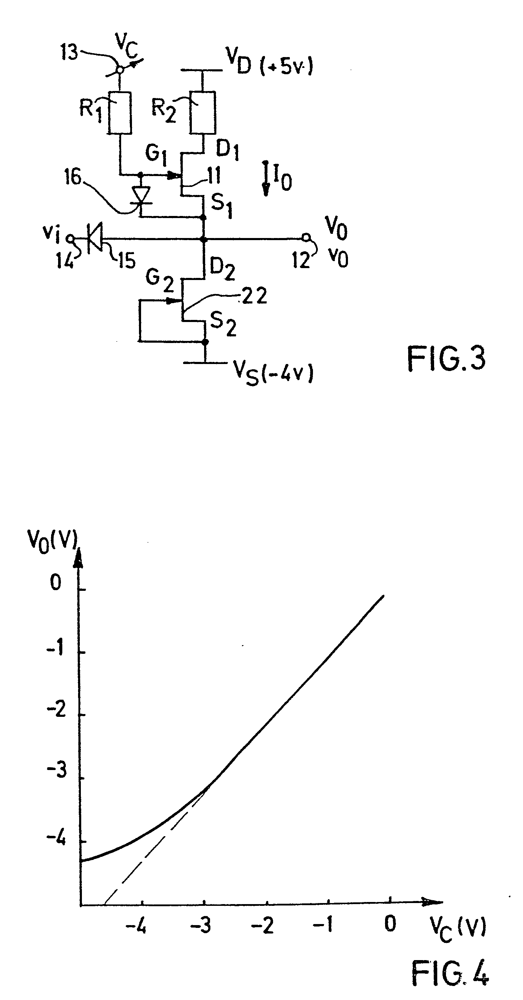

Soit Io le courant imposé par le générateur 22 de courant. La figure 2 montre que pour des valeurs suffisantes de $(V_{DS})_1$, typiquement quelques volts, la tension $(V_{GS})_1$ du transistor 11 est sensiblement constante. La relation (1) entre les tensions Vo et Vc est alors linéaire. En particulier, si le courant fourni par le générateur 22 de courant est le courant maximal $(I_{DSS})_1$ du transistor 11, $(V_{GS})_1$ est nulle et

$$Vo = Vc \quad (2),$$

la tension Vo de polarisation reproduit alors exactement, au moins dans une certaine région, les variations de la tension Vc de commande, ainsi qu'on peut le voir sur le graphique de la figure 4.

La figure 3 montre un circuit selon l'invention dans lequel le générateur 22 de courant constant est constitué par un deuxième transistor à effet de champ. Comme l'indique l'exemple de la figure 3, ce deuxième transistor 22 fonctionne à $(V_{GS})_2 = O$. Par conséquent, pour une tension $(V_{DS})_2$ suffisamment grande $(V_{DS})_2 > (IV)$, le courant $(I_{DS})_2$ entre le drain D2 et la source S2 reste sensiblement constant et égal à $(I_{DSS})_2$ lors des variations de la tension Vc continue de commande. Il est clair que, dans ce cas, le premier transistor 11 à effet de champ doit admettre au moins le courant $(I_{DSS})_2$ du deuxième transistor 22 et donc que

$$(I_{DSS})_2 \leqq (I_{DSS})_1$$

L'égalité se produit quand les deux transistors sont identiques. S'ils ne le sont pas, il est nécessaire que, à longueur de canal égale, la largeur de canal du premier transistor 11 à effet de champ soit au moins égale à la largeur de canal du deuxième transistor 22 à effet de champ.

Dans les modes de réalisation des figures 1 et 3, une résistance limitatrice R2 a été placée sur le drain D1 du premier transistor 11.

Vis à vis du signal hyperfréquence vi appliqué à la borne 14 d'entrée, l'élément capacitif 16 présente une très faible impédance et se comporte comme un court-circuit, de sorte que l'admittance du circuit est donnée par

$$Y = (g_{ds})_1 + \cfrac{1}{\cfrac{1}{(g_{ds})_2} + R2} + \cfrac{1}{R1}$$

avec $g_{ds} = \left(\dfrac{\delta i_{ds}}{\delta v_{ds}}\right) v_{gs} = cste$

L'avantage du circuit selon l'invention est que les deux transistors à effet de champ fonctionne à $V_{gs} = constante = 0$, ce qui, pour des valeurs de $V_{DS}$ assez grandes, conduit à de faibles admittances $g_{ds}$. Numériquement, pour des transistors à effet de champ sur arséniure de gallium ayant une largeur de canal de 10 µm, $1/g_{ds}$ est de l'ordre de 12 kΩ. Avec R1 > 50 kΩ et R2 = 600Ω, l'impédance du circuit est de 6 kΩ. Ainsi, lorsque le circuit destiné à recevoir la tension de polarisation ajustable Vo présente une impédance d'entrée de l'ordre de 6 kΩ, le signal de sortie vo est sensiblement égal au signal d'entrée vi.

Un avantage du circuit selon l'invention est qu'il est très facilement intégrable sur une surface très réduite. Dans ce but, et comme on peut le voir à la figure 3, l'élément capacitif 16, de même que le condensateur 15, est constitué par une diode, du type Schottky par exemple, polarisée en inverse et réalisée comme les grilles des transistors.

Un autre avantage du circuit selon l'invention est qu'il présente une faible consommation.

Des valeurs suffisantes pour $(V_{DS})_1$ et $(V_{DS})_2$ sont obtenues en appliquant, par exemple, aux bornes du circuit des tensions de polarisation $V_D$ et $V_S$ de l'ordre, respectivement, de +5V et −4V pour des variations de 3V de la tension continue Vc de commande.

**Revendications**

1. Circuit de polarisation réglable et de liaison hyperfréquence, fournissant sur une borne (12) de sortie une tension (Vo) de polarisation ajustable, en réponse aux variations d'une tension (Vc) continue de commande appliquée à une borne (13) de commande, et transmettant avec une faible atténuation un signal hyperfréquence entre une borne (14) d'entrée et la borne (12) de sortie, lesdits bornes d'entrée et de sortie étant connectées entre elles par un condensateur (15) de découplage, caractérisé en ce qu'il comporte un premier transistor (11) à effet de champ dont la source (S1) est alimentée par un générateur (22) de courant constant et est reliée à la borne (12) de sortie, tandis que la grille (G1) du transistor (11) est reliée, d'une part, à la borne (13) de commande par une résistance (R1), et, d'autre part, à la source (S1) du transistor (11) par un élément capacitif (16).

2. Circuit selon la revendication 1, caractérisé en ce que le générateur (22) de courant constant est constitué par un deuxième transistor à effet de champ dont le courant $((I_{DS})_2)$ entre le drain (D2) et la source (S2) reste sensiblement constant lors des variations de la tension (Vc) continue de commande.

3. Circuit selon la revendication 2, caractérisé en ce que, à longueur de canal égale, la largeur de canal du premier transistor (11) à effet de champ est au moins égale à la largeur de canal du deuxième transistor (22) à effet de champ.

4. Circuit selon l'une des revendications 1 à 3, caractérisé en ce que l'élément capacitif (16) est constitué par une diode polarisée en inverse.

## Claims

1. An adjustable bias and microwave coupling circuit, having an output terminal (12) on which an adjustable bias voltage (Vo) is produced in response to variations of a.d.c. control voltage (Vc) applied to a control terminal (13), which circuit transmits a microwave signal from an input terminal (14) to the output terminal (12) with a low attenuation, said input terminal and output terminal being interconnected by a decoupling capacitor (15), characterized in that it comprises a first field-effect transistor (11) whose source (S1) is driven by a constant-current generator (22) and is connected to the output terminal (12), the gate (G1) of the transistor (11) being connected to the control terminal (13) via a resistor (R1) and to the source (S1) of the transistor (11) via a capacitive element (16).

2. A circuit as claimed in claim 1, characterized in that the constant-current generator (22) comprises a second field-effect transistor whose current ($(I_{DS})_2$) between the drain (D2) and the source (S2) remains substantially constant during variations of the d. c. control voltage (Vc).

3. A circuit as claimed in claim 2, characterized in that in the case of equal channel lengths the channel width of the first field-effect transistor (11) is at least equal to the channel width of the second field-effect transistor (22).

4. A circuit as claimed in any one of the claims 1 to 3, characterized in that the capacitive element (17) is constituted by a reverse-biased diode.

## Patentansprüche

1. Schaltung zur regelbaren Vorspannungseinstellung und zur Mikrowellenverbindung, wobei in Beantwortung der Schwankungen in einer an eine Steuerklemme (13) gelegten Steuergleichspannung (Vc) an eine Ausgangsklemme (12) eine einstellbare Vorspannung (Vo) gelegt wird und mit einer geringen Abschwächung zwischen einer Eingangsklemme (14) und der Ausgangsklemme (12) ein Mikrowellensignal übertragen wird, wobei diese Eingangs- und Ausgangsklemmen über einen Entkoppelungskondensator (15) miteinander verbunden sind, dadurch gekennzeichnet, dass ein erster Feldeffekttransistor (11) vorgesehen ist, dessen Source-Elektrode (S1) von einem Konstantstromgenerator (22) gespeist wird und mit der Ausgangklemme (12) verbunden ist, während die Gate-Elektrode (G1) des Transistors (11) einerseits mit der Steuerklemme (13) über einen Widerstand (R1) und andererseits mit der Source-Elektrode (S1) des Transistors (11) über ein kapazitives Element (16) verbunden ist.

2. Schaltung nach Anspruch 1, dadurch gekennzeichnet, dass der Konstantstromgenerator (22) besteht aus einem zweiten Feldeffekttransistor, dessen Strom ($(I_{DS})_2$) zwischen der Drain-Elektrode (D2) und der Source-Elektrode (S2) bei den Schwankungen in der Steuergleichspannung (Vc) im wesentlichen konstant bleibt.

3. Schaltung nach Anspruch 2, dadurch gekennzeichnet, dass bei gleicher Kanallänge die Kanalbreite des ersten Feldeffekttransistors (11) wenigstens gleich der Kanalbreite des zweiten Feldeffekttransistors (22) ist.

4. Schaltung nach einem der Ansprüche 1 bis 3, dadurch gekennzeichnet, dass das kapazitive Element (16) durch eine invertiert vorgespannte Diode gebildet wird.

FIG.1

FIG.2

FIG.3

FIG.4